Europäisches Patentamt

European Patent Office

Office européen des brevets

(19)

(11) **EP 1 089 405 B1**

(12) **FASCICULE DE BREVET EUROPEEN**

(45) Date de publication et mention
de la délivrance du brevet:
**27.11.2002  Bulletin 2002/48**

(51) Int Cl.7: **H01S 3/109**, G02F 1/39

(21) Numéro de dépôt: **00402695.1**

(22) Date de dépôt: **29.09.2000**

(54) **Laser semiconducteur à générations paramétriques**

Halbleiterlaser mit parametrischer Lichterzeugung

Semiconductor laser comprising parametric generation

(84) Etats contractants désignés:
**DE GB**

(30) Priorité: **01.10.1999  FR 9912303**

(43) Date de publication de la demande:
**04.04.2001  Bulletin 2001/14**

(73) Titulaire: **Thales**
**75008 Paris (FR)**

(72) Inventeur: **Berger, Vincent**
**Salvador Allende 94117 Arcueil Cedex (FR)**

(56) Documents cités:
**US-A- 5 448 584**

- **OGASAWARA N ET AL: "SECOND HARMONIC GENERATION IN AN ALGAAS DOUBLE-HETEROSTRUCTURE LASER" JAPANESE JOURNAL OF APPLIED PHYSICS,JP,PUBLICATION OFFICE JAPANESE JOURNAL OF APPLIED PHYSICS. TOKYO, vol. 26, no. 8, 1 août 1987 (1987-08-01), pages 1386-1387, XP000712206 ISSN: 0021-4922**
- **TAKAO FURUSE, ISAMU SAKUMA: "Internal Second Harmonic Generation in InGaAsP DH Lasers" OPTICS COMMUNICATIONS, vol. 35, no. 3, 1 décembre 1980 (1980-12-01), pages 413-416, XP002140243**

- **ISPASOIU R G ET AL: "MEASUREMENT OF ENHANCED RADIANT POWER OF INTERNAL SECOND HARMONIC GENERATION IN INGAAS/GAAS/ALGAAS STRAINED SQW BH LDS, BY AN INDIRECT METHOD" INTERNATIONAL JOURNAL OF OPTOELECTRONICS (INCL.OPTICAL COMPUTING & PROCESSING),GB,TAYLOR & FRANCIS, LONDON, vol. 11, no. 2, 1 mars 1997 (1997-03-01), pages 127-131, XP000693964 ISSN: 0952-5432**
- **G.LEO, V.BERGER, C.OWYANG AND J.NAGLE: "Parametric Fluorescence in Oxidized AlGaAs waveguides" JOURNAL OF THE OPTICAL SOCIETY OF AMERICA B, vol. 16, no. 9, 1 septembre 1999 (1999-09-01), pages 1597-1602, XP002140244**
- **G.LEO & AL: "Parametric process in GaAs/Alox structures" NONLINEAR MATERIALS, DEVICES AND AND APPLICATION; PROCEEDINGS OF SPIE -THE NTERNATIONAL SOCIETY FOR OPTICAL ENGINEERING, vol. 3928, 24 - 25 janvier 2000, pages 94-107, XP000921156 San Jose, CA, USA**

**Description**

L'invention concerne un laser à générations paramétriques et plus particulièrement un générateur à semiconducteur permettant la génération paramétrique à partir d'une onde de pompe $\omega_1$.

La fluorescence paramétrique est en effet bien connue en optique nonlinéaire. Ce phénomène est la génération, au sein d'un matériau dit "nonlinéaire", à partir d'un faisceau dit "de pompe" (à la fréquence notée $\omega_1$), de deux faisceaux (appelés "signal" et "idler", aux fréquences $\omega_2$ et $\omega_3$). La conservation de l'énergie implique $\omega_2 + \omega_3 = \omega_1$. En plaçant le matériau nonlinéaire dans une cavité dans laquelle résonnent une ou deux fréquences générées, on peut obtenir un "oscillateur paramétrique optique" (OPO). Les OPOs sont très répandus, et utilisés comme sources cohérentes accordables de lumière à des fréquences que les lasers couvrent mal (l'infrarouge moyen ou le visible par exemple). Le problème des OPOs est leur encombrement important et leur complexité, puisque le système complet comprend un laser de pompe, un cristal nonlinéaire et des miroirs de cavité.

La difficulté de l'obtention de la génération paramétrique est liée à la nécessité de ce que l'homme de l'art appelle l'accord de phase: Du à la dispersion de l'indice optique avec la longueur d'onde, les différentes ondes interagissant ( $\omega_1$ ; $\omega_2$ et $\omega_3$) ne se déplacent pas à la même vitesse dans le matériau. Il en résulte que l'interaction nonlinéaire devient très rapidement destructive et le processus perd de son efficacité. Pour obtenir une génération paramétrique efficace, il est donc nécessaire d'obtenir l'accord de phase qui assure le maintien d'une interaction constructive tout le long de la propagation. Cet accord de phase, qui peut également s'interpréter comme une conservation du moment, s'écrit comme une relation entre les indices optiques $n_i$ aux fréquences $\omega_i$:

$$n_2\omega_2 + n_3\omega_3 = n_1\omega_1. \tag{1}$$

Le brevet US5,448,584 décrit un laser à semiconducteur à puits quantiques avec génération intégrée du second harmonique. L'accord de phase est obtenu au moyen d'un réseau gravé dans la couche de confinement supérieure. Ce principe de l'accord de phase est similaire à celui plus connu du quasi-accord de phase.

L'article de G.Leo et al intitulé "Parametric fluorescence in oxidized AlGaAs waveguides" (J.Opt. Soc. Am.B, Vol.16 N°9, septembre 1999, p.1597) réalise l'accord de phase dans des guides d'ondes en AlGaAs au moyen de multicouches de GaAs et d'AlAs oxydé pour obtenir une biréfringence de forme. Le but est l'integration monolithique d'un OPO dans une diode laser.

Dans les OPOs réalisés jusqu'à présent, différentes techniques sont utilisées pour satisfaire cette relation indispensable : par exemple l'accord de phase en utilisant des matériaux massifs biréfringents, ou encore le quasi-accord de phase, sont les deux techniques les plus couramment utilisées. Une autre méthode est l'accord de phase modal: elle consiste à utiliser la relation de dispersion des différents modes existant à l'intérieur d'un guide d'onde pour finalement vérifier la relation (1). Ceci est impossible si l'on ne considère que le mode fondamental du guide d'onde. Il faut donc utiliser des modes d'ordres différents pour les différentes ondes. Cette méthode d'accord de phase modal est celle utilisée dans le cadre de l'invention. On utilise par exemple le mode fondamental pour les ondes signal et idler mais le mode d'ordre 2 pour l'onde de pompe. Pour cette méthode, on montre que l'efficacité de la génération paramétrique est proportionnelle à l'intégrale suivante :

$$\iint dx dy \chi^{(2)}(x,y) E_{\omega_1}^{2*} E_{\omega_2}^{1} E_{\omega_3}^{1}(x,y) \tag{2}$$

L'intégrale est réalisée dans le plan perpendiculaire au guide d'onde (plan de coupe) et $E_{\omega_j}^{i}$ désigne le champ à la fréquence $\omega_j$ pour le mode d'ordre i. C'est une difficulté importante d'éviter la non-nullité de cette intégrale dès que l'on prend des modes d'ordre différent: En effet, la relation d'orthogonalité entre les modes d'ordre différent annule à priori l'intégrale :

$$\iint dx dy E_{\omega_1}^{2} E_{\omega_1}^{1} \tag{3}$$

Comme les modes fondamentaux $E_{\omega_1}^{1}$ et $E_{\omega_2}^{1}$ aux fréquences $\omega_1$ et $\omega_2$ sont, dans un guide d'onde usuel, quasi identiques, l'intégrale (2) est donc toujours très faible. C'est ce qui a jusqu'à présent limité l'emploi de cette méthode d'accord de phase modal. Selon l'invention, le dispositif est conçu précisément pour que le guide d'onde présente une intégrale (2) importante. La conclusion ici est que pour qu'une génération paramétrique dans un guide d'onde soit efficace, il faut que la relation (1) (accord de phase) soit vérifiée et que l'intégrale de recouvrement (2) soit optimisée.

L'invention concerne donc une structure laser, dans laquelle l'onde laser va être utilisée comme source de pompe pour la génération paramétrique, cette structure laser étant conçue de manière à vérifier ces deux conditions.

L'invention concerne donc un laser à semiconducteur comportant au moins deux couches en matériau optiquement non linéaire ainsi qu'un puits quantique au moins situé à l'intérieur de l'une des couches en matériau optiquement non linéaire, les épaisseurs et les indices optiques de ces deux couches sont tels que le guide d'onde constitué par ces deux couches présente une condition d'accord de phase modal pour le processus de fluorescence paramétrique entre l'onde de pompe émise par le puits quantique et les ondes de conversion paramétrique.

Les différents objets et caractéristiques de l'invention apparaîtront plus clairement dans la description qui va suivre et faite à titre d'exemple, ainsi que dans les figures annexées qui représentent :

- les figures 1a et 1b, un exemple de réalisation d'un laser selon l'invention ;
- les figures 2a à 2c, des exemples de fonctionnement d'un laser mettant en évidence l'intérêt de l'invention ;
- la figure 3, des courbes de fonctionnement du laser de l'invention en fonction de la valeur du courant d'excitation du laser de l'invention ;
- la figure 4, un autre réseau de courbes de fonctionnement du laser de l'invention ;
- la figure 5, un exemple de réalisation du laser selon l'invention ;
- la figure 6, différents diagrammes expliquant le fonctionnement du laser de l'invention ;
- les figures 7a à 7c, une variante de réalisation du laser selon l'invention ;
- les figures 8 et 9, des diagrammes permettant de déterminer le point de fonctionnement du laser.

L'invention est donc une structure laser à semiconducteurs dont les couches semiconductrices déposées ont été choisies de manière :

1) à ce que les relations de dispersion des modes se propageant dans le guide d'onde du laser vérifient la relation d'accord de phase modal pour un processus de génération paramétrique.
2) à ce que l'intégrale de recouvrement (2) soit optimisée.

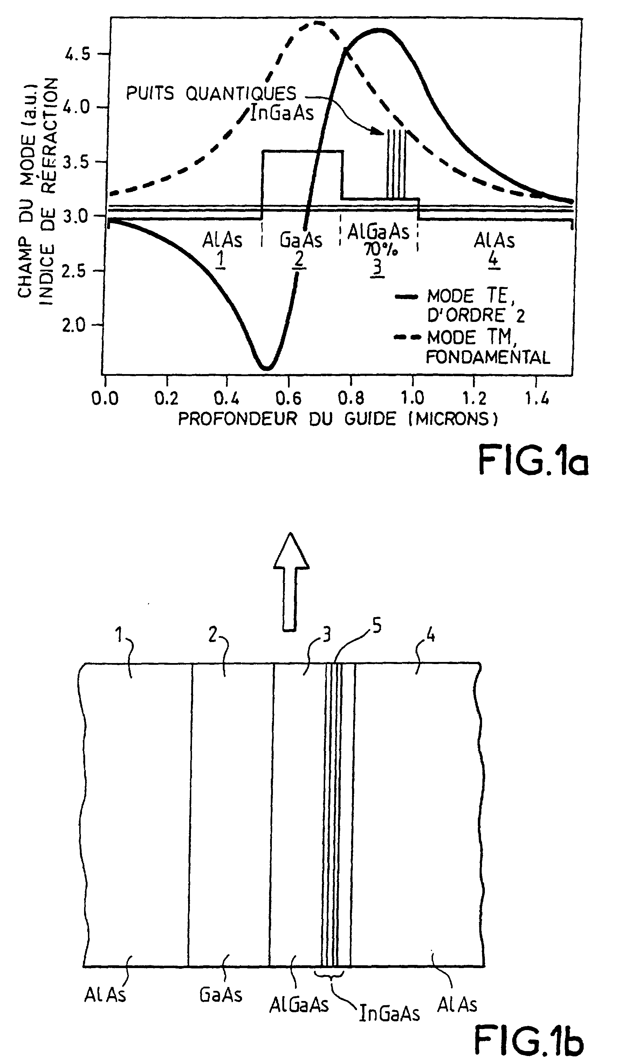

Les figures 1a et 1b représentent un exemple de réalisation d'un laser selon l'invention.

Ce laser comporte principalement un empilement de matériaux semiconducteurs comprenant au moins deux couches 2, 3 en matériaux non linéaires, un empilement de puits quantiques 5. Les deux couches 2, 3 sont enserrées entre deux couches de confinement 1 et 4. L'empilement de puits quantiques 5 est situé dans la couche de matériau non linéaire d'indice inférieur. De façon générale, s'il y avait plus de deux couches en matériaux non linéaires, le puits quantique ne serait pas de préférence dans la couche d'indice supérieur.

Les épaisseurs et les indices des couches 2 et 3 en matériaux non linéaires sont telles que le mode d'ordre 2 à la longueur d'onde $\omega_1$ et les modes fondamentaux des longueurs d'ondes $\omega_2$ et $\omega_3$ satisfassent les relations (1) et (2) précédentes.

Les épaisseurs des couches en matériaux non linéaires sont donc choisies en fonction de leurs indices de façon qu'il y ait accord de phase modal pour le processus de fluorescence paramétrique entre l'onde de pompe émise par le puits quantique et les ondes issues de la conversion paramétrique.

Il convient de préciser également que le mode de pompe ($\omega_1$) ne doit pas être situé sur le mode fondamental du guide d'onde.

Les matériaux indiqués sur les figures 1a et 1b ne sont donnés qu'à titre d'exemple non limitatif.

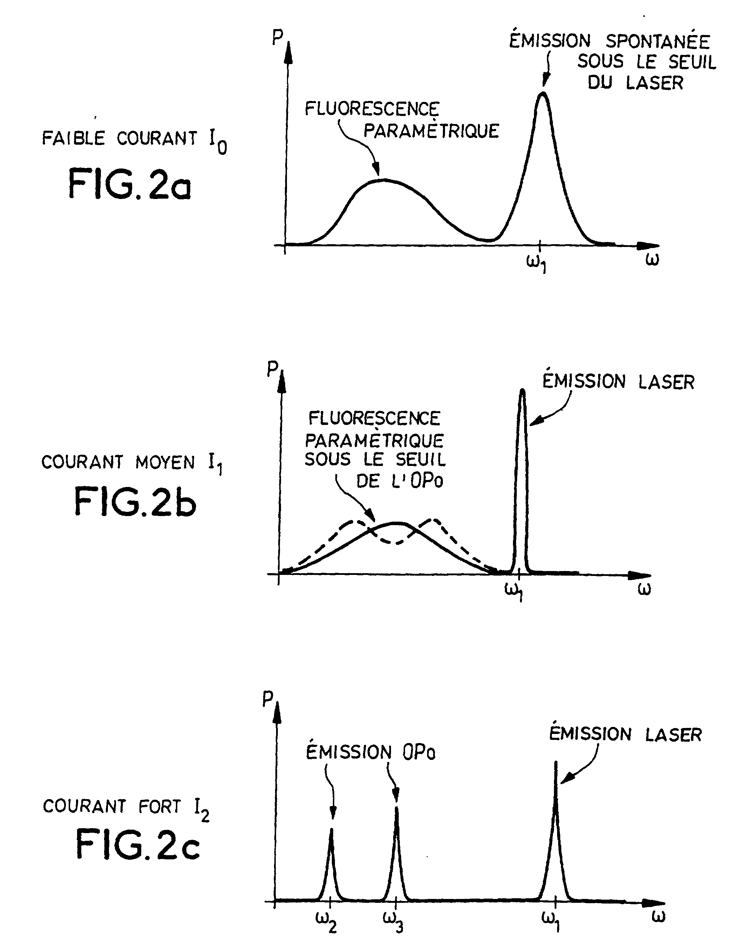

Un laser à semiconducteur réalisé selon l'invention émettra donc essentiellement trois fréquences simultanément: la fréquence dite "laser", notée ici $\omega_1$, qui résulte de l'émission stimulée dans les puits quantiques de manière totalement analogue à l'émission d'un laser à puits quantique classique; et les fréquences $\omega_2$ et $\omega_3$ qui sont l'onde signal et l'onde idler qui résulteront de la génération paramétrique de l'onde laser $\omega_1$, qui est utilisée comme onde de pompe pour ce processus nonlinéaire. A basse puissance de fonctionnement, le spectre de fluorescence paramétrique est large (continuum) et à haute puissance le dispositif fonctionne comme un oscillateur paramétrique optique et son spectre est constitué de deux fréquences $\omega_2$ et $\omega_3$ très précises. Il est possible que le dispositif soit utilisé simplement pour sa fluorescence paramétrique, sous le seuil d'oscillation paramétrique optique. Cela constitue une source de photons jumeaux utilisables par exemple en cryptographie quantique (voir figure 2b).

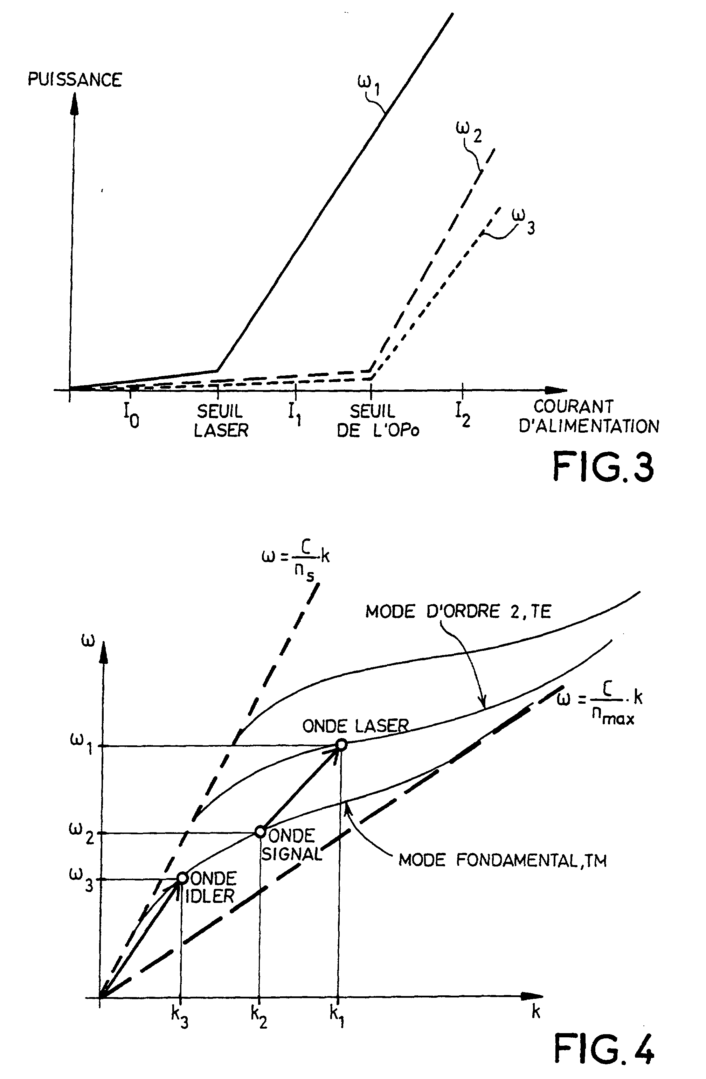

L'émission spectrale du dispositif en fonction du courant d'alimentation est résumée sur la figure 2. La puissance d'émission pour les trois fréquences $\omega_1$ $\omega_2$ et $\omega_3$ sont données schématiquement en fonction du courant d'alimentation sur la figure 3. Le dispositif présente deux seuils: Un seuil du laser proprement dit (pour l'onde à la fréquence $\omega_1$) et un seuil de l'OPO (pour les deux ondes signal et idler).

L'objet de l'invention consiste donc à placer la source laser de pompe, le milieu nonlinéaire et la cavité à l'intérieur d'un dispositif unique en semiconducteur. Les avantages sont donc comparables à ceux du laser à semiconducteur par rapport aux autres lasers : encombrement extrêmement faible, simplicité du dispositif, coût de production faible.

On va maintenant décrire l'invention de façon plus détaillée.

**Condition d'accord de phase modal (1) :**

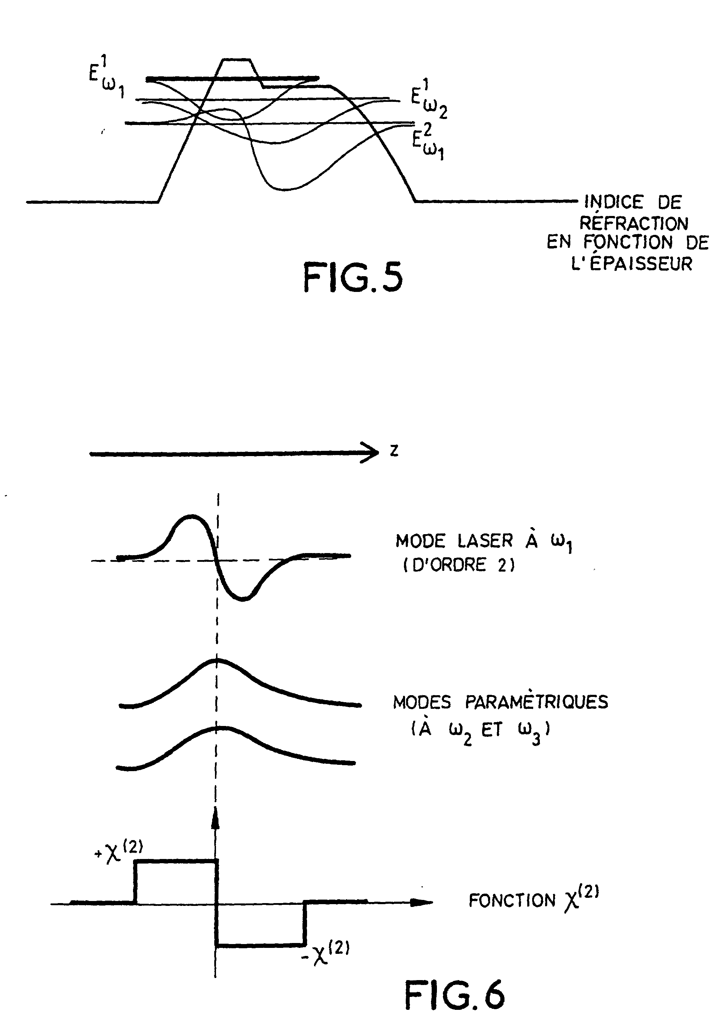

La condition (1) d'accord de phase est réalisée entre un mode d'ordre 2 pour l'onde laser et deux modes fondamentaux pour la fluorescence paramétrique. Ceci est résumé schématiquement sur la figure 4 qui représente la relation de dispersion du guide d'onde du dispositif. Sur ce diagramme de dispersion, on repère les points aux fréquences $\omega_1$ (sur le mode TE d'ordre 2), et aux fréquences $\omega_2$ et $\omega_3$ (sur les modes TM ou TE fondamentaux). La condition (1) d'accord de phase s'exprime graphiquement simplement sur cette figure: L'accord de phase est réalisé si le vecteur rejoignant l'origine et le point de plus basse fréquence est exactement égal au vecteur rejoignant les deux autres fréquences (voir figure 4).

Obtenir que la transition laser se produise sur le mode d'ordre 2 du guide d'onde n'est pas du tout quelque chose de naturel. Pour obtenir cela, ce qui est indispensable pour la condition d'accord de phase, il y a deux solutions. Il s'agit de favoriser le mode d'ordre 2 par rapport au mode fondamental, on peut donc augmenter le gain pour le mode d'ordre 2 ou alors rajouter des pertes pour le mode fondamental.

*Première solution : Augmentation du gain pour le mode d'ordre 2.*

On place les puits quantiques émetteurs au deux ventres du mode d'ordre 2. Cela augmente l'intégrale de recouvrement entre les émetteurs et le mode d'ordre 2 du guide, et donc le gain pour le mode d'ordre 2 par rapport au mode fondamental.

*Deuxième solution : Augmentation des pertes pour le mode fondamental.*

On introduit des pertes au ventre du mode fondamental, par exemple à l'aide d'un fort dopage au ventre de ce mode. Cette solution semble cependant moins favorable que la première car il n'est jamais avantageux de rajouter des pertes dans un laser.

**Optimisation de l'intégrale de recouvrement (2)** :

Les différents moyens d'optimiser l'intégrale (2) sont maintenant détaillés :

*Première solution : Réalisation d'un guide d'onde asymétrique.*

Une première solution consiste à garder un coefficient nonlinéaire constant dans la structure, mais à concevoir la structure du guide d'onde de manière à avoir une forte intégrale sur les champs non nulle. Il faut pour cela concevoir un guide d'onde asymétrique. L'asymétrie de la structure d'indice doit être optimisée de manière à augmenter l'intégrale (2). Un tel exemple de structure optimisée est présenté sur la figure 5. Pour le dessin d'une telle structure, le but est un guide d'onde dans lequel le mode fondamental à $\omega_1$ est localisé spatialement à un endroit différent du mode fondamental à $\omega_2$ et $\omega_3$.

Ainsi, l'intégrale (2), qui est faible si l'on n'y met que des champs à la même fréquence $\omega_1$ (à cause de la relation d'orthogonalité entre les modes qui est donnée en (3)) sera non nulle quand on la calcule avec le mélange de fréquences puisque les modes fondamentaux à $\omega_1$ et $\omega_2$ sont très différents spatialement.

*Deuxième solution : Variation du coefficient nonlinéaire dans l'épaisseur du guide d'onde.*

Une autre solution pour optimiser l'intégrale (2) consiste à avoir une fonction $\chi^{(2)}$ qui n'est pas constante dans le guide d'onde, qui, par exemple, change de signe. L'intégrale est alors importante comme cela est expliqué sur la figure 6. Les différentes méthodes pour obtenir un changement de signe du $\chi^{(2)}$ sont les suivantes:

1) On utilise des puits quantiques asymétriques orientés dans un sens puis dans l'autre pendant la croissance. On sait que des coefficients nonlinéaires importants sont apportés par les puits quantiques. En changeant l'orientation des puits quantiques, on change le signe du $\chi^{(2)}$ ce qui apporte l'effet voulu. Ces puits quantiques asymétriques sont également les puits quantiques émetteurs pour le laser. Dans ce cas, le coefficient nonlinéaire du matériau massif existe mais n'est pas utilisé (ou plutôt donne une contribution très faible à l'intégrale (2)).

2) On utilise le $\chi^{(2)}$ du matériau massif GaAs lui-même. Les puits quantiques nécessaires pour obtenir le laser sont alors symétriques, et ne contribuent pas au coefficient nonlinéaire $\chi^{(2)}$. Le renversement du signe du coefficient nonlinéaire est obtenu par une technique de collage de substrats retournés connu de l'homme de l'art. Ces techniques de collage de substrat avec des orientations différentes ($\chi^{(2)}$,$-\chi^{(2)}$) ont été en effet utilisées pour fabriquer des matériaux avec quasi-accord de phase. Ici, ce sont les deux moitiés de la structure laser que l'on colle face contre face, avec deux orientations cristallines opposées.

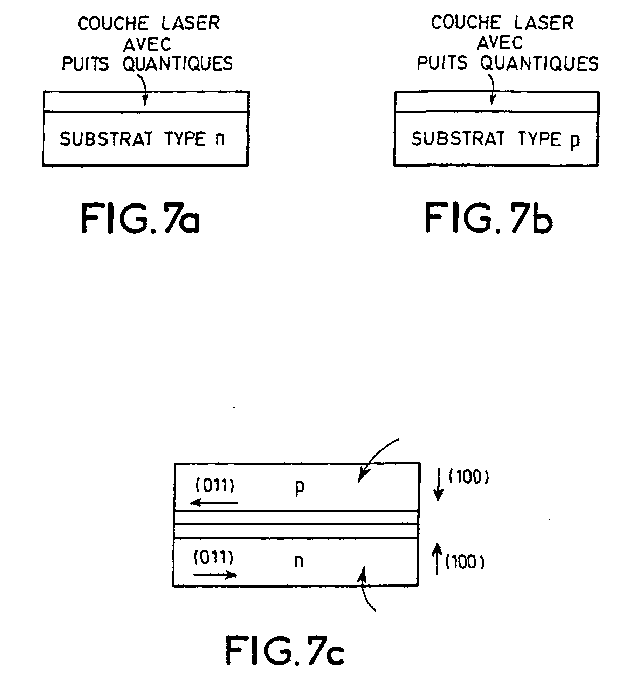

Le collage des substrats est une étape délicate car il faut obtenir finalement une structure guide d'onde laser dont l'épaisseur est constante au nanomètre près après le collage d'une part, et il faut avoir de bonnes caractéristiques électriques pour garder un bon rendement du laser d'autre part. Cette technique est résumée sur la figure 7.

La figure 1 représente un mode de réalisation préféré de l'invention. On trouvera ci-dessous un exemple de réalisation d'une telle structure.

La structure peut être la suivante:

| substrat et buffer GaAs dopé n | |
|---|---|
| AlAs dopé n | 700 nm d'épaisseur |
| GaAs | 250 nm d'épaisseur |
| AlGaAs 70 % | 250 nm d'épaisseur |

(Cette couche contient 4 puits quantiques en InGaAs émettant à 920 nm. Les caractéristiques de ces puits sont connues de l'homme de l'art)

| AlAs dopé p | 700 nm d'épaisseur |
|---|---|

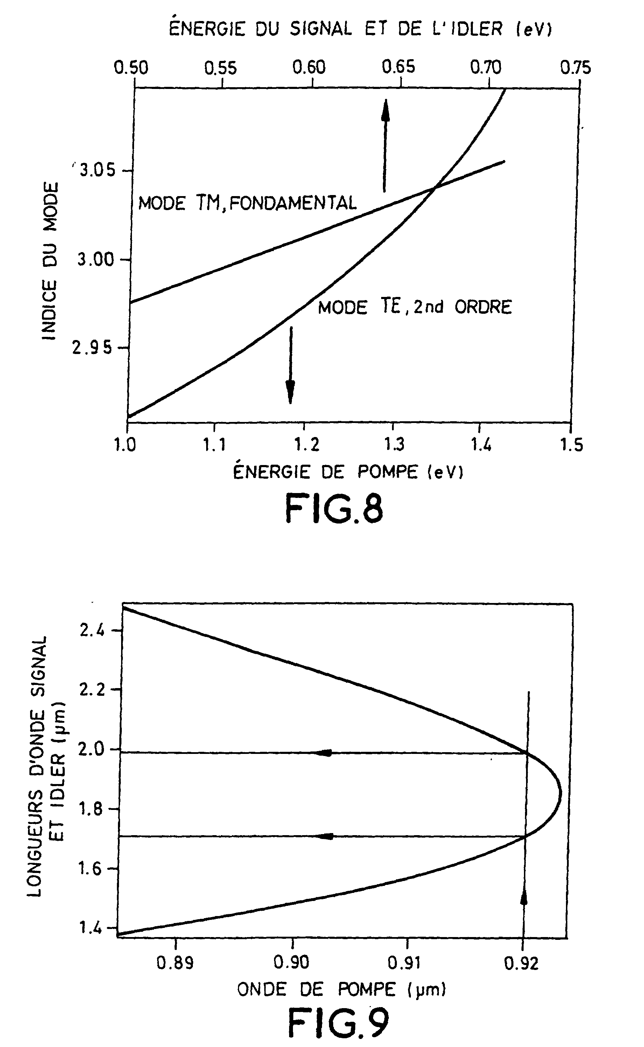

La figure 8 montre l'indice modal en fonction de l'énergie des photons dans le guide du dispositif. Ces simulations ont été effectuées avec les valeurs des indices des matériaux composant le dispositif connu dans la littérature.

On voit que pour une énergie de 1.34 eV, l'indice du mode TE de second ordre est égal à l'indice des photons d'énergie moitié (0.67 eV) pour le mode fondamental TM. On a donc accord de phase pour le processus:

$$1 \text{ photon (1.34 eV)} \rightarrow 2 \text{ photons (0.67 eV)}.$$

C'est le cas particulier de fluorescence paramétrique où les deux ondes signal et idler sont identiques, appelé dégénérescence. Autour de cette dégénérescence, beaucoup d'autres processus d'accord de phase sont possibles. Ils sont récapitulés figure 9 où l'on voit les longueurs d'onde signal et idler possibles générées à partir de l'onde de pompe en abscisse. Si les puits quantiques émettent à une longueur d'onde de 920 nm, on voit que le laser à semiconducteur (onde de pompe (à 920 nm)) va générer deux ondes à 1.7 et 2 $\mu$m, respectivement.

La figure 8 montre les modes TE, d'ordre 2 et le mode fondamental TM, d'ordre 1. Cette figure montre qu'en plaçant les puits quantiques InGaAs astucieusement dans la partie AlGaAs 70%, les puits ont un fort recouvrement avec le mode d'ordre 2, ce qui va faire en sorte que le laser à semiconducteur va laser sur le mode d'ordre 2, ce qui est capital pour le fonctionnement du dispositif selon l'invention.

## Revendications

1. Laser à semiconducteur comportant au moins deux couches (2, 3) en matériau optiquement non linéaire ainsi qu'un puits quantique au moins (5) situé à l'intérieur de l'une des couches en matériau optiquement non linéaire, **caractérisé en ce que** les épaisseurs et les indices optiques de ces deux couches (2, 3) sont tels que le guide d'onde constitué par ces deux couches présente une condition d'accord de phase modal pour le processus de fluorescence paramétrique entre l'onde de pompe ($\omega_1$) émise par le puits quantique et les ondes de conversion ($\omega_2$ et $\omega_3$) paramétrique.

**2.** Laser selon la revendication 1, **caractérisé en ce que** le mode de pompe ($\omega_1$) n'est pas situé sur le mode fondamental du guide d'onde.

**3.** Laser selon la revendication 2, **caractérisé en ce que** le puits quantique n'est pas situé dans la couche d'indice optique supérieur.

**4.** Laser selon la revendication 3, **caractérisé en ce qu'**il comporte plus de deux couches en matériau optiquement non linéaire.

**Claims**

**1.** Semiconductor laser comprising at least two layers (2, 3) of optically non-linear material and at least one quantum well (5) lying within one of the layers of optically non-linear material, **characterized in that** the thicknesses and the optical indices of these two layers (2, 3) are such that the waveguide formed by these two layers has a modal phase-tuning condition for the process of parametric fluorescence between the pump wave ($\omega_1$) emitted by the quantum well and the parametric conversion waves ($\omega_2$ and $\omega_3$).

**2.** Laser according to Claim 1, **characterized in that** the pump mode ($\omega_1$) is not on the fundamental mode of the waveguide.

**3.** Laser according to Claim 2, **characterized in that** the quantum well does not lie in the layer of higher optical index.

**4.** Laser according to Claim 3, **characterized in that** it comprises more than two layers of optically non-linear material.

**Patentansprüche**

**1.** Halbleiterlaser mit mindestens zwei Schichten (2, 3) aus einem optisch nichtlinearen Material sowie mit mindestens einer Quantensenke (5), die sich in einer der Schichten aus optisch nichtlinearem Material befindet, **dadurch gekennzeichnet, daß** die Dicke und der optische Index jeder der beiden Schichten (2, 3) so gewählt sind, daß der von diesen beiden Schichten gebildete Wellenleiter eine Bedingung des modalen Phasenabgleichs für den Prozeß der parametrischen Fluoreszenz zwischen der von der Quantensenke emittierten Pumpwelle ($\omega_1$) und den parametrischen Konversionswellen ($\omega_2$ und $\omega_3$) aufweist.

**2.** Laser nach Anspruch 1, **dadurch gekennzeichnet, daß** der Pumpmodus ($\omega_1$) nicht im Grundmodus des Wellenleiters liegt.

**3.** Laser nach Anspruch 2, **dadurch gekennzeichnet, daß** die Quantensenke sich nicht in der Schicht mit dem höheren optischen Index befindet.

**4.** Laser nach Anspruch 3, **dadurch gekennzeichnet, daß** er mehr als zwei Schichten aus optisch nichtlinearem Material enthält.

FIG.1a

FIG.1b

EP 1 089 405 B1

FAIBLE COURANT $I_0$
# FIG.2a

FLUORESCENCE PARAMÉTRIQUE

ÉMISSION SPONTANÉE SOUS LE SEUIL DU LASER

$\omega_1$   $\omega$

COURANT MOYEN $I_1$
# FIG.2b

FLUORESCENCE PARAMÉTRIQUE SOUS LE SEUIL DE L'OPo

ÉMISSION LASER

$\omega_1$   $\omega$

COURANT FORT $I_2$
# FIG.2c

ÉMISSION OPo

ÉMISSION LASER

$\omega_2$   $\omega_3$   $\omega_1$   $\omega$

8

**FIG.3**

**FIG.4**

EP 1 089 405 B1

$E^1_{\omega_1}$

$E^1_{\omega_2}$

$E^2_{\omega_1}$

INDICE DE
RÉFRACTION
EN FONCTION DE
L'ÉPAISSEUR

# FIG.5

z

MODE LASER À $\omega_1$
(D'ORDRE 2)

MODES PARAMÈTRIQUES
(À $\omega_2$ ET $\omega_3$)

$+\chi^{(2)}$

FONCTION $\chi^{(2)}$

$-\chi^{(2)}$

# FIG.6

10

EP 1 089 405 B1

COUCHE LASER
AVEC
PUITS QUANTIQUES

SUBSTRAT TYPE n

FIG.7a

COUCHE LASER
AVEC
PUITS QUANTIQUES

SUBSTRAT TYPE p

FIG.7b

(011)    p     ↓(100)

(011)    n     ↑(100)

FIG.7c

11

ÉNERGIE DU SIGNAL ET DE L'IDLER (eV)

FIG.8

FIG.9